# EUROPÄISCHE PATENTSCHRIFT

(11) **EP 1 668 969 B1**
(45) Veröffentlichungstag und Bekanntmachung des Hinweises auf die Patenterteilung: **21.10.2009**
(21) Anmeldenummer: 04723572.6
(22) Anmeldetag: 26.03.2004
(51) Int. Cl.: H05K 7/14, H01R 9/26

(54) **MODULARES ELEKTRISCHES GERÄT**
MODULAR ELECTRICAL DEVICE
APPAREIL ELECTRIQUE MODULAIRE

(30) Priorität: 25.07.2003 DE 20311587 U
(43) Veröffentlichungstag der Anmeldung: 14.06.2006
(73) Patentinhaber: Weidmüller Interface GmbH & Co. KG, 32760 Detmold (DE)
(72) Erfinder: HÖING, Michael, 32657 Lemgo (DE); HANNING, Walter, 32758 Detmold (DE); PÜSCHNER, Klaus, 32756 Detmold (DE); WÜNSCHE, Torsten, 33818 Leopoldshöhe (DE)
(74) Vertreter: Dantz, Jan Henning
(86) Internationale Anmeldenummer: PCT/EP2004/003201
(87) Internationale Veröffentlichungsnummer: WO 2005/020653

(56) Entgegenhaltungen:
- DE-A- 19 902 745
- DE-C- 19 814 810
- US-A1- 2002 182 902

## Beschreibung

Die Erfindung betrifft ein modulares elektrisches Gerät nach dem Oberbegriff des Anspruchs 1.

Derartige Geräte sind in verschiedensten Ausführungsformen, z.B. durch DE 199 02 745 bekannt. Zur Abdichtung der elektrischen Kontakte dienen im allgemeinen axiale Dichtungen zwischen dem Modulunterteil und dem Moduloberteil. Mittels Befestigungsvorrichtungen wird die Dichtkraft zwischen dem Moduloberteil und dem Modulunterteil erzeugt.

Ein Problem der bestehenden Lösungen besteht in einer möglichst platz- und raumsparenden Unterbringung der Stromschienen zur Weiterleitung eines internen Busses zur Weitergabe von elektrischen Signalen und/oder Versorgungspotentialen von Modul zu Modul.

Das Lösen dieses Problems ist die Aufgabe der Erfindung.

Die Erfindung löst diese Aufgabe durch den Gegenstand des Anspruchs 1.

Danach sind die Stromschienen im Modulober- und/oder Unterteil in verschiedenen Ebenen angeordnet und mittels wenigstens eines Distanzelementes voneinander beabstandet. Diese Anordnung baut kompakt und kostengünstig.

Besonders bevorzugt sind einige der Stromschienen jeder Ebene etwas in Richtung der korrespondierenden Modulteile, insbesondere der Moduloberteile einander überlappend höher angeordnet als die jeweils übrigen Stromschienen derselben Ebene, was es ermöglicht, auf einfache Weise auch anspruchsvollste Normen, insbesondere hinsichtlich von Kriechströmen und dgl. einzuhalten.

Zweckmäßig ist die Stromschienenanordnung in einen rahmenartigen Gehäuseabschnitt des Modulunterteils eingesetzt, welcher an das Gehäuse angeformt ist. Dabei bietet es sich ferner als besonders kompakt und sicher an, wenn in den rahmenartigen Gehäuseabschnitt zunächst eine erste Ebene der Stromschienen, sodann das Distanzelement, darüber eine zweite Ebene der Stromschienen und über letztere eine Abdeckung gesetzt ist.

Zweckmäßig sind die Stromschienen u-förmig ausgebildet und weisen jeweils einen Grundschenkel sowie zwei Längsschenkel auf, wobei an den letzteren jeweils die Kontakte ausgebildet sind.

Nach einer weiteren, einfach zu montierenden und kompakten Variante sind gegenüberliegende Seitenwandungen des rahmenartigen Gehäuseabschnitts mittels Querstegen miteinander verbunden, welche jeweils Schlitze zur Aufnahme der Grundschenkel der Stromschienen aufweisen.

Weitere vorteilhafte Ausgestaltungen sind den übrigen Unteransprüchen zu entnehmen.

Nachfolgend wird die Erfindung anhand von Ausführungsbeispielen unter Bezug auf die Zeichnung näher beschrieben. Es zeigt:
- Fig. 1: eine perspektivische Draufsicht auf ein erstes Gerät während der Montage;
- Fig. 2: eine zweite perspektivische Ansicht eines Gerätes nach Art der Fig. 1 in einer Ansicht von unten;
- Fig. 3a-d: perspektivische Ansichten eines Modulunterteils nach verschiedenen Montageschritten während seiner Herstellung; und
- Fig. 4a,b: verschiedene Ansichten einer Stromschienenanordnung für das Modulunterteil aus Fig. 1 oder 3.

Begriffe wie "oben", "unten", "vorne" oder "hinten" und dgl. beziehen sich lediglich auf die Einbausituation der in den Fig. dargestellten Ausführungsbeispiele und sind nicht einschränkend zu verstehen.

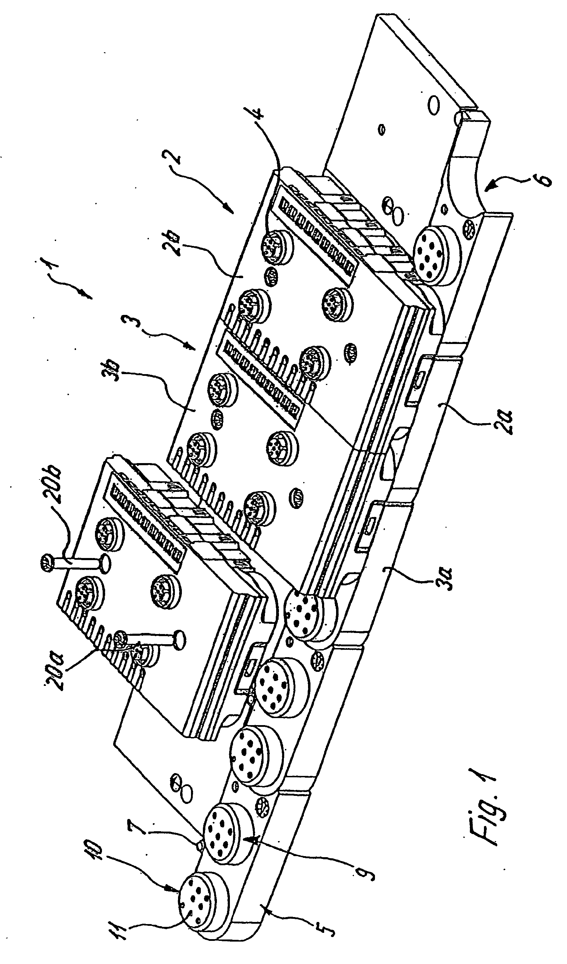

Fig. 1 zeigt ein modulartiges elektrisches Gerät 1, welches aus einer Mehrzahl aneinanderreihbarer Module 2, 3 besteht, welche jeweils ein Modulunterteil 2a, 3a und ein Moduloberteil 2b, 3b aufweisen. Die Moduloberteile 2b, 3b sind an ihrer Oberseite mit einer Mehrzahl von Anschlüssen 4 zum Anschluss von Sensoren Aktoren, Initiatoren und/oder dgl. versehen.

Das elektrische Gerät erfüllt hier beispielsweise zumindest die Normen IP65 oder IP67 oder ein höhere Norm, d.h., es ist entsprechend dieser Norm beispielsweise gegen das Eindringen von Feuchtigkeit und/oder Staub geschützt.

Zunächst werden auf einer Unterlage, beispielsweise einer Wandung einer Maschine, die Modulunterteile 2a, 3a, ... aneinandergereiht und z.B. an der Unterlage festgeschraubt, so dass sie eine mechanisch durchgängige Basis zur Befestigung der Moduloberteile 2b, 3b ausbilden, an welche sich an einem Ende der Basis z.B. ein (hier nicht dargestelltes) Gateway oder dgl. anschließen kann. Sodann werden auf die Modulunterteile 2a, 3a, jeweils die Moduloberteile 2b, 3b usw. aufgesetzt. Die Modulunterteile 2a, 3a gewährleisten insbesondere den sicheren mechanischen Halt der Moduloberteile 2b, 3b.

Sowohl die Moduloberteile 2b, 3b, ... als auch die Modulunterteile 2a, 3a, ... weisen hier jeweils in Draufsicht eine rechteckige Grundform auf. An den Modulunterteilen 2a, 3a, ... sind dabei jeweils an einem der Eckbereiche ein seitlicher Vorsprung 5 und an einem benachbarten Eckbereich eine Ausnehmung 6 ausgebildet, so dass sich eine Art seitlicher Versatz eines Randbereiches der Modulunterteile 2a, 3a zum restlichen Modulunterteil ergibt, wobei die Vorsprünge 5 und die Ausnehmungen 6 miteinander korrespondierende Formgebungen aufweisen, derart, dass jeweils die Vorsprünge 5 der Modulunterteile - z.B. 2a - in die Ausnehmungen 6 eines jeweils benachbarten Modulunterteils - z.B. 3a - eingreifen.

Die Vorsprünge 5 und Ausnehmungen 6 sind hier jeweils abgerundet ausgebildet.

Nach Fig. 1 sind an die Seiten der Modulunterteile 2a, 3a jeweils nach oben vorkragende Stifte 7 angeformt, welche zum Eingriff in eine korrespondierende Bohrung 8 wiederum jeweils benachbarter Modulunterteile 2a, 3a dienen und derart benachbarte Modulunterteile 2a, 3a vor dem Festschrauben an der Unterlage ausrichten und gegen ein Auseinanderziehen sichern.

Auf den Modulunterteilen 2a, 3a, ... sind jeweils zwei nebeneinanderliegende Steckervorsprünge 9, 10 ausgebildet, welche senkrecht nach oben von den Modulunterteilen 2a, 3a vorstehen und jeweils eine Mehrzahl elektrischer Buchsenkontakte 11 aufweisen. Korrespondierende Buchsenkontakte 11 der jeweils benachbarten Steckervorsprünge 9, 10 sind hier jeweils elektrisch leitend miteinander verbunden. Typischerweise dient ein Teil der Buchsenkontakte 11 zur Spannungsversorgung im Gerät bzw. für anzuschließende Sensoren oder dgl. und ein anderer Teil zur Datenübertragung im Gerät.

Die Moduloberteile - z.B. 3b - sind so dimensioniert, dass sie jeweils den einen der Steckervorsprünge - 9 - ihres eigenen Modulunterteils - also z.B. 3a - und jeweils einen der Steckervorsprünge - 10 - auf dem Vorsprung 5 des jeweils einen benachbarten Modulunterteils - also z.B. 2a - übergreifen.

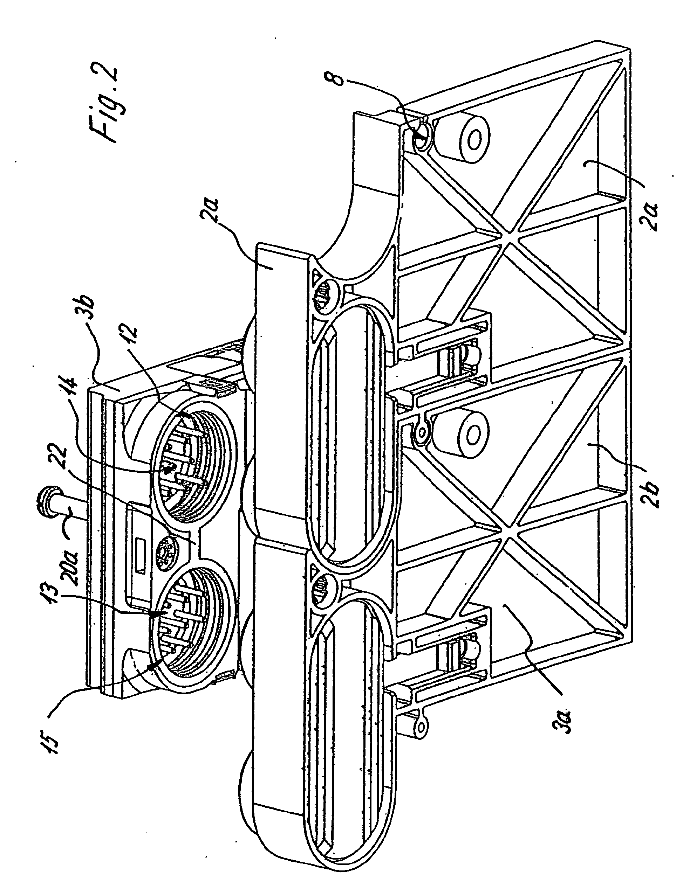

Gemäß Fig. 2 weisen die Moduloberteile 2b, 3b an ihrer Unterseite jeweils zwei benachbarte Steckerbuchsen 12, 13 auf, welche zur Aufnahme der zwei Steckervorsprünge 9, 10 dienen und Stiftkontakte 14 aufweisen, welche zum Eingriff in die Buchsenkontakte 11 der Steckervorsprünge 9, 10 dienen. Auf diese Weise wird eine Weiterleitung von Daten und Versorgungsspannungen von Modul zu Modul realisiert.

Zur Gewährleistung der benötigten Schutzklasse sind die elektrische Verbindungen zwischen den Modul- unter- und -oberteilen 2a, 2b; 3a, 3b mittels einer Dichtkappe 15 gegeneinander abgedichtet.

Zum Erreichen einer genügenden axialen Dichtkraft und einer genügenden Rüttelsicherheit werden mittels einer Befestigungsvorrichtung - zum Beispiel mit Schrauben 20a, b (Fig. 1, 2) oder hier bevorzugten, clipsartigen Elementen - die Moduloberteile 2b, 3b jeweils mittels einer Kraft F an den zugehörigen Modulunterteilen 2a,3a befestigt, derart, dass eine Axialkraft zwischen den beiden Elementen wirkt, aus der eine genügend große Dichtwirkung am Deckelabschnitt 18 bzw. zwischen den Steckervorsprüngen 9, 10 und den Steckerbuchsen 12, 13 resultiert. Die Befestigungsvorrichtungen 20 halten die Moduloberteile 2b, 3b derart auf den Modulunterteilen 2a, 3a, dass sich diese nicht unbeabsichtigt - beispielsweise infolge von Rüttelbeanspruchungen - lösen können.

Ergänzend wirkt zwischen den Stecker- und Buchsenteilen, d.h., zwischen den Steckervorsprüngen 9, 10 und den Steckerbuchsen 12, 13 nicht nur eine axiale Dichtkraft sondern vorteilhaft auch eine Dichtkraft in radialer Richtung. Gerade die Kombination aus axialer Dichtkraft, unterstützt durch die Befestigungsvorrichtungen und radialer Dichtkraft am Umfang der Dichtkappe 15 bewirkt eine optimale Dichtig- und Festigkeit der Anordnung.

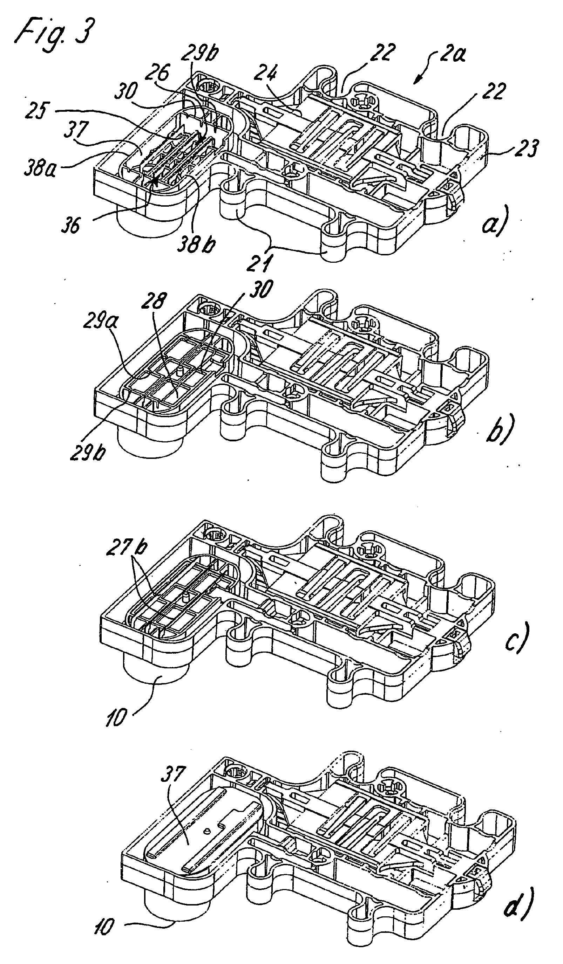

Nach Fig. 3 sind anstelle der Abstützstifte 7 an die aneinander liegenden Seiten der Modulunterteile 2a, 3a, ... jeweils zwei (wenigstens einer) hier voneinander beabstandete, puzzleartige Vorsprünge 21 angeformt, welche zum Eingriff in auf der gegenüberliegenden Seite eines benachbarten Modulunterteils 2a, 3a, ... ausgebildete korrespondierende puzzleartige Ausnehmungen 22 ausgebildet sind. Dies richtet die Modulunterteile 2a, 3a, ... beim Aneinanderreihen und Montieren jeweils zweifach aus und hält sie, bevor sie an einer Unterlage - z.B. mittels zwei Schrauben -festgeschraubt werden können. Derart werden Positionsabweichungen bei der Montage sicher und auf einfache Weise vermieden.

Das Modulunterteil 2 der Fig. 3 umfasst ein Gehäuse 23, wobei im Gehäuse 23 als Befestigungsvorrichtung ein clipsartiges Schieberelement 24 verschieblich angeordnet ist, das zur Verriegelung sowie zur Entriegelung der Moduloberteile 2b, 3b, ... an den Modulunterteilen 2a, 3a, ... dient.

Unterhalb der beiden Steckervorsprünge 9, 10 ist eine Stromschienenanordnung 36 im Gehäuse 23 angeordnet, welche zur Verbindung der elektrischen Kontakte der beiden Steckervorsprünge 9, 10, hier der Buchsenkontakte 11, dient, um die elektrischen Signale sowie Versorgungsspannungen und dgl. von Modul zu Modul weiterzuleiten.

Die Stromschienenanordnung 36 aus zueinander parallelen Stromschienen 27 ist in einen rahmenartigen Gehäuseabschnitt 37 eingesetzt, welcher an die Unterseite des Gehäuses angeformt ist, und zwar in dem Abschnitt des Gehäuses 23, der direkt unterhalb der beiden Steckervorsprünge 9, 10 liegt.

Zwei gegenüberliegende Seitenwandungen 38a, b des rahmenartigen Gehäuseabschnitts 37 sind mittels Querstegen 25 miteinander verbunden, welche jeweils Schlitze 26 zur Aufnahme der Grundschenkel 40 im wesentlichen u-förmiger Stromschienen 27 aufweisen (Fig. 3a). Ein Teil der Stromschienen 27 in einer ersten Ebene I verbindet hier jeweils korrespondierende, näher aneinander liegende Buchsenkontakte 11 der beiden Steckervorsprünge 9, 10 miteinander.

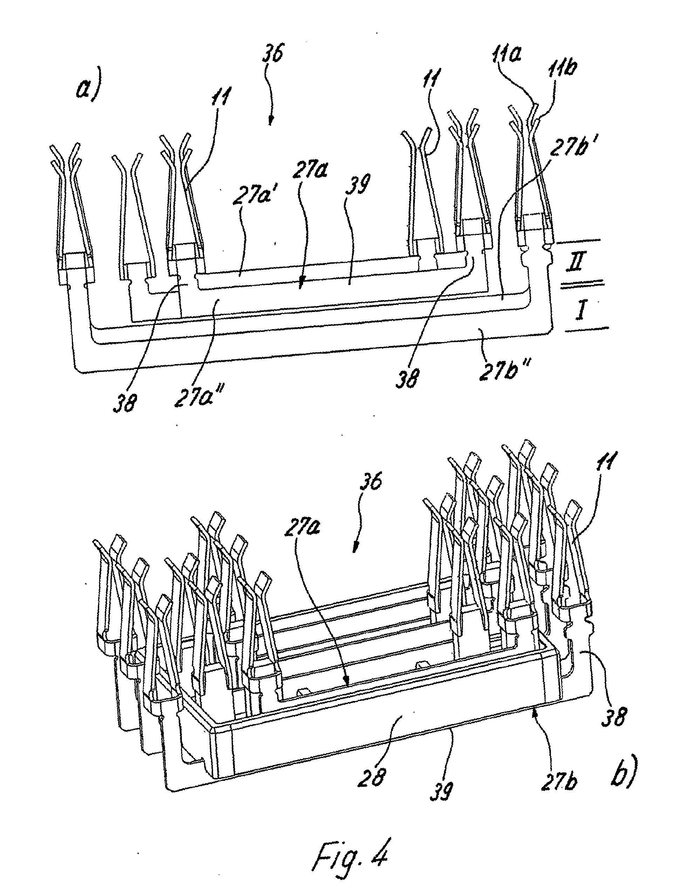

Nach Fig. 3b wird über die ersten Stromschienen 27a - siehe auch Fig. 4 - nach ihrem Einsetzen in der rahmenartigen Gehäuseabschnitt ein Distanzelement 28 gesetzt, welches wiederum einen äußeren Rahmen, Querstege im Rahmen sowie ggf. auch eine Zwischenabdeckung aufweisen, kann. Sodann werden die äußeren bzw. weiter voneinander beabstandeten Kontakte 11 durch weitere U-förmige Stromschienen 27b in einer weiteren Ebene II miteinander verbunden, deren Grundschenkel wiederum in Schlitze 29a des Distanzelementes 28 und weitere Schlitze 29b in Querstegen 30 im rahmenartigen Gehäuseabschnitt 37 eingreifen (Fig. 3c).

Sodann wird über die weiteren Stromschienen 27b wiederum eine Abdeckung 32 gesetzt, welche den rahmenartigen Gehäuseabschnitt 37 vollständig abschließt bzw. abdeckt. Optional kann das Gehäuse an seiner Unterseite auch noch von einem weiteren Bodenteil vollständig abgedeckt werden (hier nicht dargestellt).

Fig. 4a und b zeigen eine Seitenansicht und eine perspektivische Ansicht der Stromschienenanordnung aus Fig. 3.

In Fig. 4 ist gut zu erkennen, dass sämtliche der Stromschienen 27 u-förmig ausgebildet sind, wobei die beiden Längsschenkel 40 jeweils an ihren Enden mit je einem der hier tulpenartigen Buchsenkontakte 11 versehen sind.

Die ersten inneren Stromschienen 27a weisen gleich lange Grundschenkel 39 auf, sie sind einerseits nebeneinander und auch axial in Richtung der Grundschenkel überlappend versetzt zueinander angeordnet, so dass auch die Buchsenkontakte 11 jeweils zueinander versetzt liegen, was es ermöglicht, eine besonders dichte Anordnung der inneren Stromschienen 27 zu verwirklichen.

Dagegen sind die Stromschienen 27b der äußeren Ebene länger als die Stromschienen 27a der inneren Ebene, so dass die äußeren Stromschienen 27b die inneren Stromschienen 27a quasi einschließen.

Anzumerken ist noch dass sowohl die inneren Stromschienen 27a als auch die oberen Stromschienen 27b in dem zwei Ebenen I, II nicht alle genau auf derselben Höhe angeordnet sind, sondern dass einige der Stromschienen 27a' und 27b' mit den Buchsenkontakten 11 a jeweils etwas in Richtung der korrespondierenden Modulteile, hier der Moduloberteile 2b, einander überlappend höher angeordnet sind als die jeweils übrigen Stromschienen 27a" und 27b" derselben Ebene I oder II, um die Spannungsversorgungsanschlüsse etwas relativ zu den Anschlüssen für die Datenleitungen jeweils etwas voreilend auszugestalten.

Diese etwas höhere Anordnung korrespondiert mit einer entsprechenden Auslegung des Distanzelement 28 und/oder des rahmenartigen Gehäuseabschnittes 24 und/oder des Modulunterteils 2a sowie mit einer korrespondierenden voreilenden Auslegung der Kontakte im korrespondierenden Modulteil (hier nicht dargestellt). Dies ermöglicht es, auf einfache Weise auch anspruchsvollste Normen, insbesondere hinsichtlich von Kriechströmen und dgl. einzuhalten.

### Bezugszeichen

| | |
|---|---|
| elektrisches Gerät | 1 |
| Module | 2, 3 |
| Anschlüsse | 4 |
| Modulunterteile | 2a, 3a, ... |
| Moduloberteile | 2b, 3b, ... |
| Vorsprung | 5 |
| Ausnehmung | 6 |
| Stifte | 7 |
| Bohrung | 8 |
| Steckervorsprünge | 9, 10 |
| Buchsenkontakte | 11 |
| Steckerbuchsen | 12, 13 |
| Stiftkontakte | 14 |
| Dichtkappe | 15 |
| Schlitze | 19 |
| Befestigungsvorrichtung | 20 |
| Vorsprünge | 21 |
| Ausnehmungen | 22 |
| Gehäuse | 23 |
| rahmenartiger Gehäuseabschnitt | 24 |
| Querstege | 25 |
| Schlitze | 26 |
| Stromschienen | 27, 27a, 27b |
| Distanzelement | 28 |
| Schlitze | 29a,b |
| Querstege | 30 |
| Abdeckung | 32 |
| Stromschienenanordnung | 36 |
| rahmenartiger Gehäuseabschnitt | 37 |
| Seitenwandungen | 38 |
| Grundschenkel | 39 |
| Längsschenkel | 40 |
| Ebenen | I. II |

## Patentansprüche

1. Elektrisches Gerät mit Modulen (2, 3) zur Realisierung eines modularen I/O-Systems,
a) wobei die Module (2) jeweils ein Modulunterteil (2a, 3a) und ein Moduloberteil (2b, 3b) aufweisen und wobei vorzugsweise die Moduloberteile (2b, 3b) mit einer Mehrzahl von Anschlüssen (4) zum Anschluss von Sensoren Aktoren, Initiatoren und/oder dgl. versehen sind,
b) wobei an den Modulober- und Modulunterteilen (2a, 3a; 2b, 3b) korrespondierende Steckervorsprünge (9, 10) und/oder Steckerbuchsen (12, 13) ausgebildet sind, die eine Mehrzahl an Kontakten (11) aufweisen, welche in den Modulober- und/oder Unterteilen (2a, 3a; 2b, 3b) mittels einer Stromschienenanordnung (36) mit einer Mehrzahl an Stromschienen (27) leitend miteinander verbunden sind,
c) wobei ein Teil der Stromschienen (27) zur Datenübertragung und ein weiterer Teil der Stromschienen (27) zur Energieversorgung dient,
**dadurch gekennzeichnet, dass**
d) die Stromschienen in verschiedenen Ebenen im Modulober- und/oder Unterteilen (2a, 3a; 2b, 3b) angeordnet und mittels wenigstens eines Distanzelementes (28) voneinander beabstandet sind.

2. Elektrisches Gerät nach Anspruch 1, **dadurch gekennzeichnet, dass** einige der Stromschienen (27a' und 27b') jeder Ebene (I. II) etwas in Richtung der korrespondierenden Modulteile, insbesondere der Moduloberteile (2b) einander überlappend höher angeordnet sind als die jeweils übrigen Stromschienen (27a" und 27b") derselben Ebene (I, II).

3. Elektrisches Gerät nach Anspruch 1 oder 2, **dadurch gekennzeichnet, dass** die Stromschienenanordnung (36) in einen rahmenartigen Gehäuseabschnitt (37) eingesetzt ist, welcher an das Gehäuse (23) in dem Abschnitt des Gehäuses (23) angeformt ist.

4. Elektrisches Gerät nach Anspruch 3, **dadurch gekennzeichnet, dass** in den Rahmen zunächst eine erste Ebene der Stromschienen (27a), sodann das Distanzelement (28), darüber die zweite Lage der Stromschienen (27b) und über letztere eine Abdeckung (32) gesetzt ist.

5. Elektrisches Gerät nach einem der Ansprüche 1 bis 4, **dadurch gekennzeichnet, dass** die Stromschienen u-förmig ausgebildet sind und jeweils einen Grundschenkel (39) sowie zwei Längsschenkel (40) aufweisen, wobei an den letzteren jeweils die Kontakte (11) ausgebildet sind.

6. Elektrisches Gerät nach einem der vorstehenden Ansprüche, **dadurch gekennzeichnet, dass** gegenüberliegende Seitenwandungen (38a, b) des rahmenartigen Gehäuseabschnitts (37) mittels Querstegen (25) miteinander verbunden sind, welche jeweils Schlitze (26) zur Aufnahme der Grundschenkel (39) der Stromschienen (27) aufweisen.

7. Elektrisches Gerät nach einem der vorstehenden Ansprüche, **dadurch gekennzeichnet, dass** das Distanzelement (28) einen äußeren Rahmen, Querstege im Rahmen sowie ggf. auch eine Zwischenabdeckung aufweist.

8. Elektrisches Gerät nach einem der vorstehenden Ansprüche, **dadurch gekennzeichnet, dass** das Distanzelement (28) in den rahmenartigen Gehäuseabschnitt (37) eingesetzt ist und innere sowie äußere Stromschienen (27a, 27b) voneinander trennt.

9. Elektrisches Gerät nach einem der vorstehenden Ansprüche, **dadurch gekennzeichnet, dass** die Abdeckung (32) den rahmenartigen Gehäuseabschnitt (37) vollständig abdeckt.

10. Elektrisches Gerät nach einem der vorstehenden Ansprüche, **dadurch gekennzeichnet, dass** die Stromschienen (27b) der äußeren Ebene länger sind als die Stromschienen (27a) der inneren Ebene, so dass die Stromschienen (27b) der einen Ebene die Stromschienen (27a) der anderen Ebene einschließen.

11. Elektrisches Gerät nach einem der vorstehenden Ansprüche, **dadurch gekennzeichnet, dass** die inneren Stromschienen (27) gleich lange Grundschenkel (39) aufweisen und dass die inneren Stromschienen versetzt zueinander angeordnet sind.

## Claims

1. Electrical device with modules (2, 3) for the implementation of a modular I/O system,
a) wherein each module (2) comprises a module bottom part (2a, 3a) and a module top part (2b, 3b) and wherein the module top parts (2b, 3b) are preferably provided with a plurality of connections (4) for connecting sensors, actuators, initiators and/or the like,
b) wherein corresponding plug projections (9, 10) and/or sockets (12, 13) with a plurality of contacts (11) which are conductively connected to one another on the module top and/or bottom parts (2a, 3a; 2b, 3b) by means of a bus bar assembly (36) with a plurality of bus bars (27) are formed on the module top and bottom parts (2a, 3a; 2b, 3b),
c) wherein one part of the bus bars (27) is designated for data transmission and another part of the bus bars (27) is designated for energy supply,
**characterised in that**
d) the bus bars are disposed at different levels in the module top and/or bottom parts (2a, 3a; 2b, 3b) and spaced from one another by means of at least one spacer element (28).

2. Electrical device according to claim 1, **characterised in that** some of the bus bars (27a' and 27b') of each level (I, II) are located slightly higher in the direction of the corresponding module parts, in particular the module top parts (2b), while overlapping one another than the remaining bus bars (27a" and 27b") of the same level (I, II).

3. Electrical device according to claim 1 or 2, **characterised in that** the bus bar assembly (36) is installed into a frame-like housing section (37) which is integrally formed on the housing (23) in the section of the housing (23).

4. Electrical device according to claim 3, **characterised in that** a first level of bus bars (27a) is initially installed into the frame, followed by the spacer element (28), on top thereof by the second level of bus bars (27b) and on top of the latter by a cover (32).

5. Electrical device according to any of claims 1 to 4, **characterised in that** the bus bars are U-shaped, each having a base (39) and two longitudinal legs (40), the latter carrying the contacts (11).

6. Electrical device according to any of the preceding claims, **characterised in that** opposite side walls (38a, b) of the frame-like housing section (37) are joined to one another by means of transverse webs (25) provided with slots (26) for the accommodation of the bases (39) of the bus bars (27).

7. Electrical device according to any of the preceding claims, **characterised in that** the spacer element (28) comprises an outer frame, transverse webs in the frame and possibly an intermediate cover.

8. Electrical device according to any of the preceding claims, **characterised in that** the spacer element (28) is installed into the frame-like housing section (37) and separates the inner and outer bus bars (27a, 27b) from one another.

9. Electrical device according to any of the preceding claims, **characterised in that** the cover (32) completely covers the frame-like housing section (37).

10. Electrical device according to any of the preceding claims, **characterised in that** the bus bars (27b) of the outer level are longer than the bus bars (27a) of the inner level, so that the bus bars (27b) of one level enclose the bus bars (27a) of the other level.

11. Electrical device according to any of the preceding claims, **characterised in that** the inner bus bars (27) have bases (39) of equal length and **in that** the inner bus bars are offset relative to one another.

## Revendications

1. Appareil électrique pourvu de modules (2, 3) permettant la réalisation d'un système E/S modulaire,
a) le module (2) présentant respectivement une partie inférieure de module (2a, 3a) et une partie supérieure de module (2b, 3b) et les parties supérieures de module (2b, 3b) étant de préférence pourvues d'une pluralité de connexions (4) pour le raccordement de capteurs acteurs, d'initiateurs et/ou similaires,
b) au niveau des parties inférieures et supérieures de module (2a, 3a ; 2b, 3b) étant formées des saillies de fiche (9, 10) et/ou des douilles de fiche (12, 13) correspondantes, lesquelles présentent une pluralité de contacts (11) qui, dans les parties inférieures et/ou supérieures de module (2a, 3a ; 2b, 3b), sont raccordés les uns aux autres de manière conductrice au moyen d'un agencement de rails de contact (36) pourvu d'une pluralité de rails de contact (27),
c) une partie des rails de contact (27) servant à la transmission de données et une autre partie des rails de contact (27) servant à l'alimentation en énergie,
**caractérisé en ce que**
d) les rails de contact sont disposés à différents niveaux dans les parties inférieures et/ou supérieures de module (2a, 3a ; 2b, 3b) et sont espacés les uns par rapport aux autres au moyen d'au moins un élément d'écartement (28).

2. Appareil électrique selon la revendication 1, **caractérisé en ce que,** légèrement dans la direction des parties de module correspondantes, notamment des parties supérieures de module (2b), quelques-uns des rails de contact (27a' et 27b') de chaque niveau (I, II) sont disposés plus haut que les autres rails de contact respectifs (27a" et 27b") du même niveau (I, II) de manière chevauchée les uns par rapport aux autres.

3. Appareil électrique selon la revendication 1 ou 2, **caractérisé en ce que** l'agencement de rails de contact (36) est installé dans un tronçon de logement en forme de cadre (37), lequel est moulé dans le tronçon du logement (23) au niveau du logement (23).

4. Appareil électrique selon la revendication 3, **caractérisé en ce que,** dans le cadre, est tout d'abord placé un premier niveau de rails de contact (27a), puis l'élément d'écartement (28), au-dessus la seconde couche de rails de contact (27b) et enfin un couvercle de protection (32).

5. Appareil électrique selon l'une quelconque des revendications 1 à 4, **caractérisé en ce que** les rails de contact sont en forme de U et présentent respectivement une branche principale (39), ainsi que deux branches longitudinales (40), les contacts (11) étant respectivement formés au niveau de ces dernières.

6. Appareil électrique selon l'une quelconque des revendications précédentes, **caractérisé en ce que** des parois latérales opposées (38a, b) du tronçon de logement en forme de cadre (37) sont reliées les unes aux autres au moyen de traverses (25), lesquelles présentent respectivement des fentes (26) pour recevoir la branche principale (39) des rails de contact (27).

7. Appareil électrique selon l'une quelconque des revendications précédentes, **caractérisé en ce que** l'élément d'écartement (28) présente un cadre extérieur, des traverses dans le cadre et, le cas échéant, également un couvercle intermédiaire.

8. Appareil électrique selon l'une quelconque des revendications précédentes, **caractérisé en ce que** l'élément d'écartement (28) est installé dans le tronçon de logement en forme de cadre (37) et sépare les rails de contact intérieurs et extérieurs (27a, 27b) les uns des autres.

9. Appareil électrique selon l'une quelconque des revendications précédentes, **caractérisé en ce que** le couvercle de protection (32) recouvre entièrement le tronçon de logement en forme de cadre (37).

10. Appareil électrique selon l'une quelconque des revendications précédentes, **caractérisé en ce que** les rails de contact (27b) du niveau extérieur sont plus longs que les rails de contact (27a) du niveau intérieur, de sorte que les rails de contact (27b) du premier niveau entourent les rails de contact (27a) de l'autre niveau.

11. Appareil électrique selon l'une quelconque des revendications précédentes, **caractérisé en ce que** les rails de contact intérieurs (27) présentent une branche principale (39) de même longueur, et **en ce que** les rails de contact intérieurs sont disposés de manière décalée les uns par rapport aux autres.
